# EUROPEAN PATENT APPLICATION

(11) **EP 0 997 559 A1**
(43) Date of publication of application: **03.05.2000**
(21) Application number: 98203519.8
(22) Date of filing: 22.10.1998
(51) Int. Cl.: C30B 11/00, C30B 7/12, C25D 1/10

(54) **A method to form thin films and thick layers of single crystal structure by electro-plating**

(71) Applicant: Westbury Development Europa B.V., 5704 MT Helmond (NL)
(72) Inventor: Wisotzki, F. J., 5704 MT Helmond (NL)

(57) **Abstract**

The invention covers a new process of crystal growth by electro-plating. Electro-plating is widely used to enhance materials to avoid corrosion and other ways of discolouring of the surfaces, which might in cases of optical applications reduce the power of the optics.

Such coatings, commonly used on materials which have a grain structure, do have the tendency to peel off their substrates after some time, because the growth of oxide from the impurities residing in the grain boundaries underneath, can not be stopped by such coatings.

Not even coatings produced under highest vacuum do hold very much longer. The only solution to improve the life time and the optical quality of such coatings is to have them deposited on single crystal surfaces, which have no grain boundaries and best is, the surface of such a single crystal substrate receives the coating before it is exposed to air or is mechanically touched.

There are surface properties on such undamaged, unmachined single crystal surfaces which are not available on any other state of a material surface. To use those single crystal surfaces for electro-plating in commonly used material applications opens a wide reange of industrial prosperity.

## Description

### State of the art:

to create thin films or thicker layers by electro-plating is a commonly known process and the materials used have commonly a form of a grain structured basis on which another material is plated, coming from a solution into which the base material is lowered and used as an anode. Applying electrical current between this anode and the cathode forces the solved material from the solution to deposit itself onto the anode and covers it, by adapting the same structure as the anode has. For example, using a stainless steel anode of any form and lowering this form into a copper bath will create a copper layer on the stainless steel anode with the same grain structure the anode itself is formed of.

### Description of the invention:

single crystal materials are usually grown to cylindrical forms and from those cylindrical forms discs or otherwise shaped bodies are cut by mechanical means, which includes spark erosion. All those cutting or grinding processes do significant harm to the crystal structure of the surface, usually beyond any possible repair to restore the former physical properties of the single crystal structure. Even chemical etching has been found and is classified to be such a mechanical disturbance of the single crystal structure.

With the inventions claimed in US patent 4,949,642 to melt and grow single crystal bodies to their final form and shape without any further mechanical machining necessary and as claimed in German patent DE 34 00 774 to grow those bodies to a surface quality of optical grade by using a optically machined graphite replica, new types of single crystal bodies could be produced, having a usable final form.

Single crystal bodies produced by those two inventions bear physical properties which have never been seen before, which were used for example as a laser mirror to reflect high energy CO2-laser beams of a magnitude, impossible to be handled by a copper mirror with a grain structure.

A similar negative result in loosing reflectivity could be seen at that moment, when the naturally grown surface of a single crystal got polished and the structure disturbed by mechanical treatment.

Investigating the behaviour of a single crystal surface, grown to a final form and with a surface of high quality in a electrolytic bath showed a very interesting result in the first trial.

Dipping a copper plate of such novel crystal structure into a silver- or gold cyanide solution, without having any electrical current applied showed, an immediate coverage of the single crystal surface by a layer of silver or gold.

Repeating this test several times ended always in the same result, a total coverage of the copper by a layer of a few microns thickness of the agent from the solution, in this test, silver and gold.

Coating a portion of the single crystal plate with an electrically non-conductive lacquer, which was removed after the coating had taken place, showed a step between the two materials which could be examined properly in a high resolution microscope and an electron-microscope.

The layer of silver or gold proved to have the same orientation of single crystal structure as the copper bodies surface had and the stacking between the surface had taken place in a perfect way, adapting the perfection and also all imperfections of the single crystal surface of the copper body.

Further it was found that the interface between the two materials, the copper body and the layer of silver or gold was free of any strain, due to the match of the orientation adapted by the thin layer of silver or gold.

Repeating the test by lowering a gold coated copper single crystal into a silver cyanide solution showed exact the same result as it had been found by lowering the blank copper crystal into a silver cyanide solution. This way sandwich structures of thin single crystal layers of different materials could be formed, with almost no strain in the individual interfaces between the layers.

In a second step the single crystals were used as an anode by applying electrical current to them and the electro-plating took place in a similar way, but with a much higher rate of deposition and thick layers of a few hundred microns could be formed onto the copper single crystal body.

Masking portions of the single crystal body with a non-conductive coating resulted in a coating which was only present on one side of the hollow body of the copper single crystal, for example having the shape of a hollow cone, where the inside of the hollow cone was protected by this coating.

This way only the outside of the hollow cone was electro-plated with a layer of single crystal structured silver, with the identical orientation of the crystal structure of the surface of the outside of the hollow cone of copper.

Using a chemical solvent the rather thin single crystal copper cone could be etched away from the now ― by electro-plating ― grown silver cone. This promising effect resulted in the invention to grow single crystals of any form or shape by electro-plating, in particular from such materials which can not be grown in a mould or form as described in the US patent 4,949,642 and DE 34 00 774.

This invention is of great industrial significance because coatings of any kind seem to peel off their substrates on which they are deposited by the following causes:
1. oxidation growing from inside the grain structure of the body on which the plating has been deposited and which can not be stopped by anything
2. strain implanted into the surface of the body by mechanical machining onto which the plating has been deposited and which reacts in particular under rapid thermal changes coming from the environment.

Those two destructive factors do not exist if electro-plating is used in the form as described in this invention and for which a patent is applied for.

Further detail is provided by reference to the following illustrations:

### Figure 1

shows the body of a flat single crystal substrate on to which a portion of a electro-plated layer has been deposited.

### Figure 2

shows the body of a flat single crystal substrate on to which a portion of a electro-plated layer has been deposited and on to this deposited layer another electro-plated layer has been deposited, demonstrating the formation of a sandwich structure.

### Figure 3

shows the hollow body of a cone where the inside of the cone has been shielded by a lacquer and the outside of the cone has been electro-plated by a layer of another material. The cone can be chemically separated from the electro-plated layer, leaving a single crystal hollow cone, formed by electro-plating.

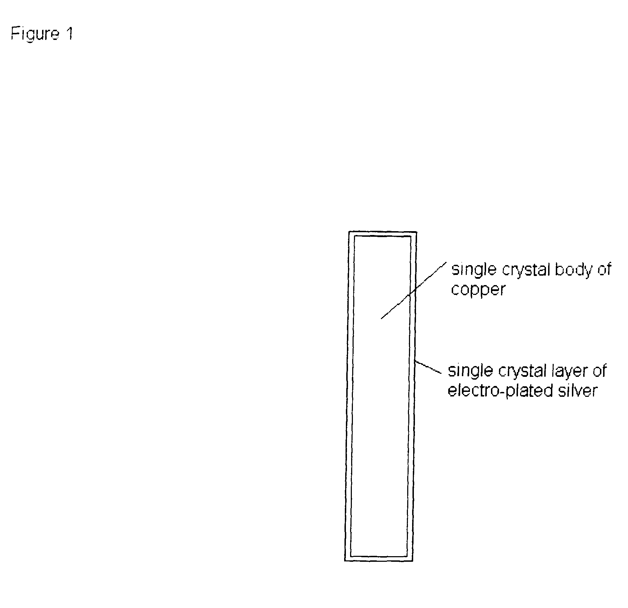

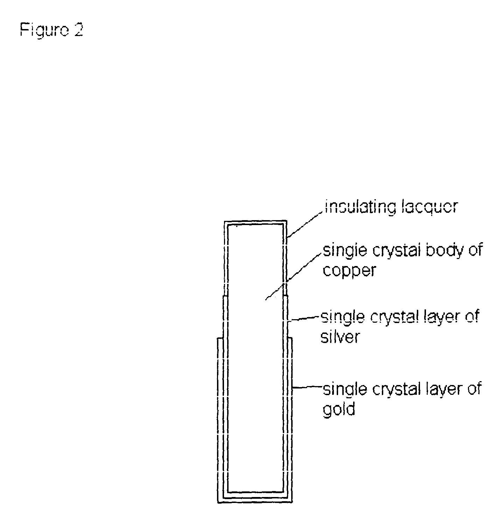

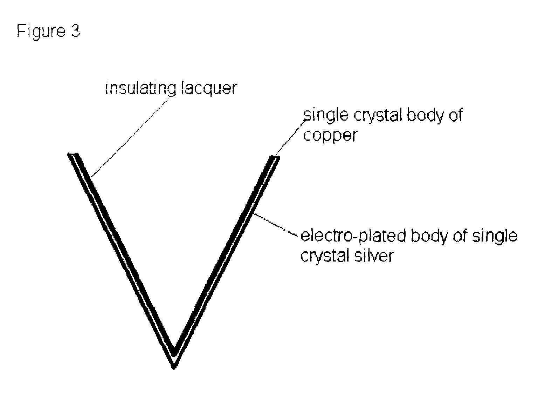

## Claims

1. the formation of a single crystal structure of any material possible and any thickness possible to be grown on to a single crystal body by electro-plating, where the body of the single crystal material has been grown to the final shape and form and the surface is of optical quality, grown in and replicated from a high quality graphite or boron-nitride mould.

2. the formation of a single crystal body from any material possible and any thickness possible to be grown on to a single crystal body by Electro-plating, where the single crystal body grown by Electro-plating can be chemically separated from the single crystal body used as a substrate during the process of Electro-plating.

3. the formation of a combination of thin layers of single crystal structure by Electro-plating, stacked on top of each other in form of a sandwich, with different electrical and thermal conductivity, bearing all the same orientation of the substrate on to which they were deposited by Electro-plating.

4. a process of Electro-plating in which a single crystal body of any material grown to the final form and shape and which has mechanically unharmed surfaces, is used to be plated with any other material possible from a solution.
